Europäisches Patentamt

European Patent Office

Office européen des brevets

(19)

(11) Veröffentlichungsnummer: **0 083 706**
**B1**

(12) EUROPÄISCHE PATENTSCHRIFT

(45) Veröffentlichungstag der Patentschrift:
07.01.87

(51) Int. Cl.⁴: **H 03 M 1/68,** H 03 J 7/28

(21) Anmeldenummer: **82110447.8**

(22) Anmeldetag: **12.11.82**

(54) **Digital/Analog-Wandler.**

(30) Priorität: **13.01.82 DE 3200748**

(43) Veröffentlichungstag der Anmeldung:
**20.07.83 Patentblatt 83/29**

(45) Bekanntmachung des Hinweises auf die Patenterteilung:
**07.01.87 Patentblatt 87/2**

(84) Benannte Vertragsstaaten:
**AT FR IT**

(56) Entgegenhaltungen:
**DE - A - 1 926 077**
**FR - A - 1 593 778**
**FR - A - 2 125 717**
**FR - A - 2 490 429**
**US - A - 3 995 266**

(73) Patentinhaber: **Blaupunkt-Werke GmbH,**
**Robert-Bosch-Strasse 200, D-3200 Hildesheim (DE)**

(72) Erfinder: **Baum, Wolfgang, Ing.(grad.),**
**Plötzenstrasse 102, D-3200 Hildesheim (DE)**
Erfinder: **Trinks, Rüdiger, Dipl.-Phys.,**
**Fritz-Reuter-Weg 7, D-3384 Liebenburg 1 (DE)**

(74) Vertreter: **Eilers, Norbert, Dipl.-Phys., Blaupunkt-Werke**
**GmbH Robert-Bosch-Strasse 200, D-3200 Hildesheim**
**(DE)**

## Beschreibung

Die Erfindung betrifft einen Digital/Analog-Wandler.

Sie geht aus von einem Digital/Analog-Wandler nach dem Oberbegriff des Patentanspruchs.

Solche Digital/Analog-Wandler sind aus der französischen Patentschrift FR 1 593 778 bekannt. Infolge Fertigungstoleranzen in den einzelnen n-bit-Wandlern wird hierbei der Spannungshub bei den einzelnen Schritten nicht immer gleich sein.

## Aufgabe der Erfindung

Verwendet man solche Wandler zum Steuern eines Suchlaufs eines elektronisch abstimmbaren Empfängers, vorzugsweise eines Autoradios, dann wird der Abstimmbereich nicht gleichförmig überstrichen. Es besteht von daher die Aufgabe sicherzustellen, dass beim Suchlauf kein empfangbarer Sender übersprungen werden kann.

## Gegenstand der Erfindung

Die besonderen Merkmale des Gegenstandes der Erfindung sind im kennzeichnenden Teil des Patentanspruchs angegeben.

## Vorteil der Erfindung

Durch die erfindungsgemässe Massnahme ist es möglich, Toleranzen in der Schrittweite des Wandlers mit der grösseren Schrittweite insoweit auszugleichen, dass beim Erzeugen der rampenförmigen Abstimmsteuerspannung nur Abweichungen in einer Richtung möglich sind, so dass gegebenenfalls nur ein erneuter Durchlauf eines bereits durchsuchten Abschnitts des Abstimmbereiches erfolgt.

Weitere Vorteile ergeben sich aus der Beschreibung und der beigefügten Zeichnung.

## Zeichnung

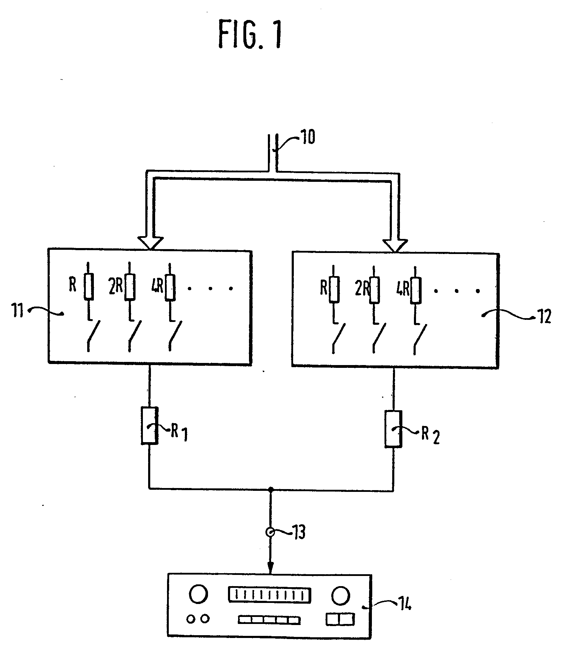

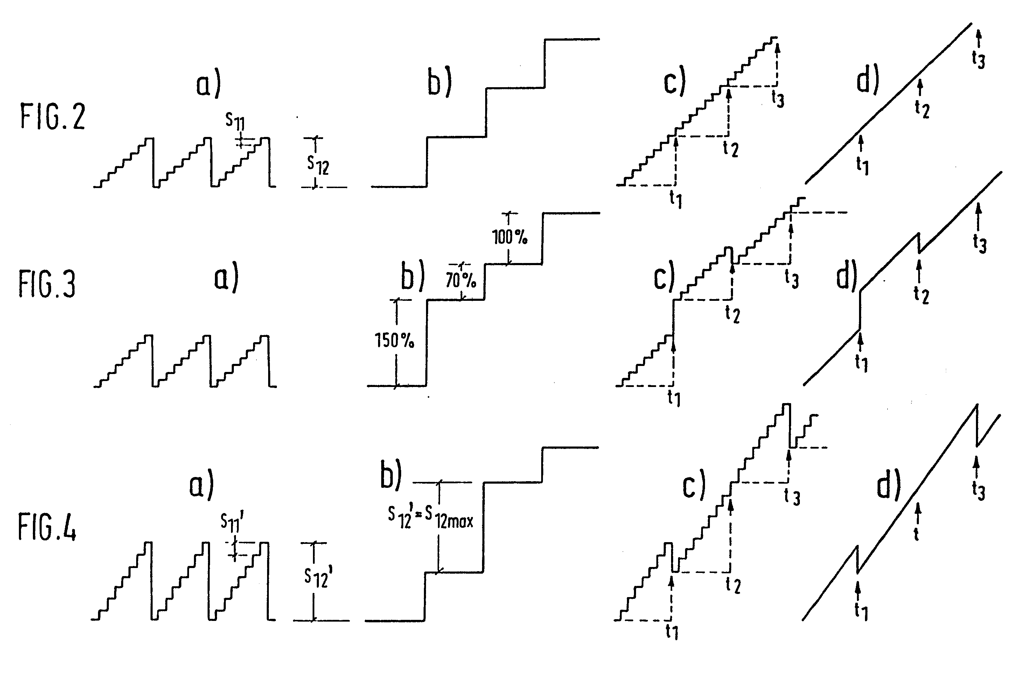

Die Erfindung ist in der Zeichnung dargestellt und wird in der nachfolgenden Beschreibung näher erläutert. Es zeigen Figur 1 ein Blockschaltbild einer Ausführungsform eines erfindungsgemässen Digital/Analog-Wandlers; Figuren 2a bis d bis 4a bis d zeitliche Signalverläufe zur Erläuterung des in Figur 1 dargestellten Ausführungsbeispiels.

## Beschreibung des Ausführungsbeispiels

In Figur 1 ist mit 10 eine Datenleitung bezeichnet, auf der ein digitales Eingangssignal anliegt. Die Datenleitung 10 führt zu einem ersten n-bit-Wandler 11 sowie zu einem zweiten n-bit-Wandler 12. Die Wandler 11, 12 verfügen über Widerstandsnetzwerke R, 2R, 4R, 8R..., deren Widerstandswerte exponentiell gestuft sind. Die Widerstände sind dabei durch Schalter einschaltbar, so dass auf diese an sich bekannte Weise eine Digital/Analog-Wandlung des Eingangssignales möglich ist. Dem Wandler 11 ist ein Ausgangswiderstand $R_1$, dem Wandler 12 ist ein Ausgangswiderstand $R_2$ zugeordnet, wobei die Widerstände R1, R2 auf einen gemeinsamen Ausgang 13 führen. Durch Dimensionierung der Widerstände $R_1$, $R_2$ lässt sich die Schrittweite der Wandler 11, 12 einstellen, wobei unter Schrittweite der Anstieg des Ausgangssignales verstanden wird, der sich dann einstellt, wenn der Eingang mit einem digitalen Taktsignal beaufschlagt ist.

Wird auf der Datenleitung 10 ein digitales Taktsignal geführt, entsteht, wie weiter unten noch ausführlich geschildert, am Ausgang 13 ein treppenförmiges Signal, das durch Glättungsmassnahmen in eine rampenförmiges Signal überführbar ist. Dieses rampenförmige Signal dient im Ausführungsbeispiel gemäss Figur 1 zum Steuern eines Sendersuchlaufes eines Autoradios 14. Es versteht sich dabei jedoch von selbst, dass erfindungsgemäss das Signal am Ausgang 13 auch zur Steuerung anderer Gerätefunktionen verwendet werden kann. Da, wie weiter unten ebenfalls noch ausführlich geschildert werden wird, durch erfindungsgemässe Massnahmen sicher verhindert werden kann, dass die Rampenfunktion Vorwärtssprünge aufweist, ist das Signal am Ausgang 13 jedoch besonders gut für Suchläufe geeignet, da hierdurch sichergestellt wird, dass keine vom Suchlauf zu überstreichenden Bereiche übersprungen werden. Hierdurch kann die Spannung am Ausgang 13 besonders vorteilhaft auch für Messzwecke, beispielsweise in Ortungsgeräten oder analytischen Messgeräten verwendet werden.

Die Funktion des in Figur 1 dargestellten Ausführungsbeispieles wird nachstehend anhand der Figuren 2 bis 4 erläutert:

Figur 2a zeigt dabei das Ausgangssignal des ersten Wandlers 11, wenn dieser von der Datenleitung 10 her mit einem Taktsignal beaufschlagt ist. Wie man sieht, ergibt sich eine Treppenfunktion die periodisch zurückgesetzt wird, wobei durch Dimensionierung des Widerstandes $R_1$ eine Schrittweite $S_{11}$ eingestellt ist. Demgegenüber ergibt sich am Ausgang des zweiten Wandlers 12 ein treppenförmiges Ausgangssignal, wie dies in Figur 2b dargestellt ist. Die Schrittweite ist dabei entsprechend auf einen Betrag $S_{12}$ eingestellt, der der Gesamtschrittweite des ersten Wandlers 11 bis zum Überlauf entspricht. Die Zeitdauer der Einzelschritte des zweiten Wandlers 12 ist dabei durch geeignete Taktmassnahmen so eingestellt, dass jedem Hochlauf bis zum Überlauf des ersten Wandlers 11 ein Schritt des zweiten Wandlers 12 entspricht.

Sind beide Wandler 11, 12 als n-bit-Wandler ausgebildet und entsprechen $2^n$ Schritte $S_{11}$ des ersten Wandlers 11 genau einem Schritt $S_{12}$ des zweiten Wandlers 12, entsteht durch Zusammenführung der Ausgangssignale eine Treppenspannung, wie sie in Figur 2c dargestellt ist. Mit $t_1$, $t_2$, $t_3$ sind dabei die Zeitpunkte bezeichnet, an denen der zweite Wandler 12 das Ausgangssignal des ersten Wandlers 11 übernimmt, so dass sich insgesamt die in Figur 2c gezeigte gleichmässige Treppenspannung ergibt. Durch geeignete Glättungsmassnahmen kann nun der Verlauf der Spannung in Figur 2c in einem solchen gemäss Figur 2d überführt werden. Da durch die vorstehend beschriebenen Zuordnungen von Schrittzahl und Schrittweite ein monotoner Verlauf des Signalverlaufes gemäss 2c gewährleistet ist, ergibt sich insgesamt eine streng lineare Rampenfunktion nach Figur 2d.

Bei Verwendung von einfachen Wandlern 11, 12 mit geschalteten, exponentiell gestuften Widerstandsnetzwerken können jedoch erhebliche Toleranzen in der Schrittweite auftreten, wie dies in Figur 3b schematisch veranschaulicht ist. Die dort eingezeichneten drei Schritte betragen 150%, 70% bzw. 100% der Sollschrittweite. Nimmt man der Einfachheit halber die Schrittweite des ersten Wandlers 11 gemäss Figur 3a als konstant an, ergibt sich eine Treppenfunktion, wie sie in Figur 3c dargestellt ist bzw. eine daraus abgeleitete, geglättete Rampenfunktion gemäss Figur 3d. Da der erste Schritt mit 150% in der Schrittweite stark erhöht ist, ergibt sich zum Zeitpunkt $t_1$ ein Vorwärtssprung in der Rampenfunktion gemäss Figur 3d. Entsprechend ergibt sich durch die verkleinerte zweite Schrittweite zum Zeitpunkt $t_2$ ein Rücksprung, während am Ende des dritten Sprunges, der mit 100% die Sollweite hat, zum Zeitpunkt $t_3$ ein monotoner Übergang vorliegt.

Die zu den Zeitpunkten $t_1$ und $t_2$ auftretenden Diskontinuitäten können sich bei Verwendung der Rampenfunktion gemäss Figur 3 in einem Suchlauf dann störend auswirken, wenn zu überstreichende Bereiche übersprungen werden. Dies ist beim Vorwärtssprung zum Zeitpunkt $t_1$ der Fall, während der Rückwärtssprung zum Zeitpunkt $t_2$ nur zur Folge hat, dass ein bestimmter Bereich nochmals überstrichen wird. Dieser zweite Fehler ist jedoch beispielsweise bei einem Sendersuchlauf in einem Autoradio nicht kritisch, während der erste Fehler zum Zeitpunkt $t_1$ vermieden werden muss, da durch diesen Vorwärtssprung möglicherweise wichtige Rundfunkstationen, beispielsweise solche, die Verkehrsfunk ausstrahlen, übersprungen werden können.

In weiterer Ausgestaltung der Erfindung sind daher Massnahmen vorgesehen, die nur Rückwärtssprünge, nicht jedoch Vorwärtssprünge zulassen.

Hierzu ist, wie dies aus Figur 4a ersichtlich ist, durch Einstellen des Widerstandes $R_1$ die Schrittweite $S_{11}'$ so eingestellt, dass sich eine Gesamtschrittweite bis zum Überlauf des ersten Wandlers 11 von $R_{12}'$ ergibt, die der maximal zu erwartenden Schrittweite $S_{12max}$ entspricht oder grösser sein kann. Dann ergibt sich eine Treppenfunktion gemäss Figur 4c bzw. eine geglättete Rampenfunktion gemäss Figur 4d. Wie man ohne weiteres sieht, erscheinen aufgrund der Dimensionierung der Schritte $S_{11}'$ nur noch Rückwärtssprünge zu den Zeitpunkten $t_1$, $t_3$, während bei Auftreten der maximalen Schrittweite $S_{12max}$ des zweiten Wandlers 12 zum Zeitpunkt $t_2$ ein monotoner Übergang der Funktionen gemäss Figur 4c und d auftritt. Auf diese Weise ist demnach gewährleistet, dass alle zu überstreichenden Bereiche des Suchlaufes überstrichen werden und kein Überspringen einzelner Bereiche mehr auftritt.

## Patentanspruch

Digital/Analog-Wandler für die schrittweise Erzeugung von rampenförmigen Steuerspannungen mit zwei n-bit-Wandlern, die zur Erzielung einer 2n-bit-Auflösung parallel angeordnet sind und auf einem gemeinsamen Ausgang arbeiten, wobei die Schrittweite der einzelnen Wandler mittels ihrer Ausgangswiderstände einstellbar sind und $2^n$ Schritte des einen Wandlers wenigstens näherungsweise einem Schritt des zweiten Wandlers entsprechen, dadurch gekennzeichnet, dass um zu vermeiden, dass beim Steuern eines Suchlaufs eines elektronisch abstimmbaren Empfängers zu überstreichende Bereiche infolge ungleicher Schrittweiten des zweiten Wandlers übersprungen werden das Verhältnis der Ausgangswiderstände untereinander so bemessen ist, dass $2^n$ Schritte des ersten Wandlers (11) gleich oder grösser sind als die maximale Schrittweite ($S_{12max}$) des zweiten Wandlers (12).

## Claim

Digital/analog converter for generating ramp-shaped control voltages step by step using two n-bit converters which are arranged in parallel to achieve a 2n-bit resolution and work into a common output, in which arrangement the step size of the individual converters can be adjusted by means of their output resistors and $2^n$ steps of one converter correspond at least approximately to one step of the second converter, characterised in that the ratio of the output resistors with respect to each other is dimentioned in such a manner that $2^n$ steps of the first converter (11) are equal to or greater than the maximum step size ($S_{12max}$) of the second converter (12) in order to avoid that, when controlling a station-seeking operation of an electronically tunable receiver, ranges to be swept are skipped due to unequal step sizes of the second converter.

## Revendication

Convertisseur numérique/analogique pour obtenir graduellement des tensions de commande par étapes avec deux convertisseurs à n chiffres binaires, qui pour obtenir une résolution à 2n chiffres binaires sont disposés en parallèle et opèrent sur une sortie commune, les pas de progression des convertisseurs individuels étant susceptibles d'être réglés au moyen de leurs résistances de sortie, et les progressions $2^n$ de l'un des convertisseurs correspondant au moins approximativement à une progression du second convertisseur, convertisseur caractérisé en ce que pour éviter que, lorsque la recherche d'un récepteur électroniquement raccordable des zones à balayer soit sautée par suite de pas de progression inégaux du second convertisseur, le rapport des résistances de sortie entre elles est dimensionné de façon que $2^n$ pas du premier convertisseur (11) soient égaux ou supérieurs au pas de progression maximal ($S_{12max}$) du second convertisseur (12).

# FIG. 1

FIG.2
a)    b)    c)    d)

FIG.3
a)    b)    c)    d)

FIG.4
a)    b)    c)    d)

0 083 706